# EUROPEAN PATENT APPLICATION

(11) **EP 4 647 675 A1**
(43) Date of publication of application: **12.11.2025**
(21) Application number: 23914417.3
(22) Date of filing: 17.11.2023
(51) Int. Cl.: F24F 5/00

(54) **MACHINE ROOM TEMPERATURE CONTROL METHOD AND APPARATUS, AND DEVICE AND STORAGE MEDIUM**

(30) Priority: 03.01.2023 CN 202310002535
(71) Applicant: China Mobile Energy Technology Beijing Co. Ltd., Beijing 100085 (CN); China Mobile Group Design Institute Co., Ltd., Beijing 100080 (CN); CHINA MOBILE COMMUNICATIONS GROUP CO., LTD., Beijing 100032 (CN)
(72) Inventor: LIU, Baochang, Beijing 100080 (CN); ZHENG, Hong, Beijing 100080 (CN); LI, Yusheng, Beijing 100080 (CN); ZHAO, Hepeng, Beijing 100080 (CN); DI, Hanyu, Beijing 100080 (CN); WANG, Wei, Beijing 100080 (CN); HU, Manli, Beijing 100080 (CN); LI, Ao, Beijing 100080 (CN); CHENG, Lei, Beijing 100080 (CN); LUO, Yongqiang, Beijing 100080 (CN); WANG, Qifan, Beijing 100080 (CN); LIU, Qiang, Beijing 100080 (CN); GUO, Yunzheng, Beijing 100080 (CN); HE, Qian, Beijing 100080 (CN)
(74) Representative: Maiwald GmbH
(86) International application number: PCT/CN2023/132454
(87) International publication number: WO 2024/146282

(57) **Abstract**

Disclosed in the present application are a machine room temperature control method and apparatus, and a device and a storage medium. The machine room temperature control method comprises: receiving, in real time, exhaust temperature sent by an exhaust temperature sensor, when the exhaust temperature is greater than a preset exhaust temperature threshold value, receiving environmental data sent by an environmental information sensor, and determining a heat dissipation mode on the basis of the environmental data, wherein heat dissipation modes comprise a fresh-air mode, a cooling mode and a heat-pipe mode; and controlling a heat dissipation system, which corresponds to the heat dissipation mode, to perform heat dissipation on a cabinet, wherein heat dissipation systems corresponding to the fresh-air mode, the cooling mode and the heat-pipe mode are respectively a fresh-air system, a cooling system and a heat-pipe system. In the present application, a suitable heat dissipation system is selected from among a plurality of heat dissipation.

## Description

### CROSS-REFERENCE TO RELATED APPLICATIONS

This application is based on and claims priority to Chinese patent application NO. 202310002535.1, filed on January 3, 2023, the entire contents of which are incorporated herein by reference.

### TECHNICAL FIELD

The disclosure relates to the technical field of air conditioning system and, in particular to a method and an apparatus for computer room temperature control, a device and a storage medium.

### BACKGROUND

The heat dissipation of devices in a communication computer room generally adopts a computer room air conditioning. The computer room air conditioning adopts the traditional voltage-based refrigeration, thereby, the energy consumption is relatively high.

To reduce energy consumption, the related art usually adopts a fresh air technology or a heat exchange technology for heat dissipation of the devices in the communication computer room. However, both the fresh air technology and the heat exchange technology have the following limitations.

For a fresh air system, it can only be used in time periods when the outdoor air quality is good and the air humidity is low. If the above conditions are not met, problems such as system fouling which reduces heat dissipation efficiency, and excessive humidity in the computer room may arise. For the heat pipe system, it can only be used in the time periods when the temperature difference between indoor and outdoor air is significant, otherwise the heat dissipation efficiency is low. Thus, the above methods are only effective during certain periods of the year, and cannot adapt to the complex environmental changes throughout the entire year or autonomously adjust the computer room temperature, resulting in a low energy-saving efficiency of the system for the communication computer room temperature control.

### SUMMARY

The purpose of the disclosure is to provide a method and an apparatus for computer room temperature control, a device and a storage medium, to solve the technical problems in the related art that the existing methods are only effective during certain periods of the year, and cannot adapt to the complex environmental changes throughout the entire year or autonomously adjust the computer room temperature, resulting in a low energy-saving efficiency of the system for communication computer room temperature control.

To realize the above purpose, a method for computer room temperature control is provided in the disclosure. The method is executed by an apparatus for computer room temperature control in a system for computer room temperature control, the system includes a computer room fresh air system, a computer room, a cabinet ventilation system, a refrigeration system and a heat pipe system, in which the cabinet ventilation system includes a cabinet and an air exhaust temperature sensor, and the computer room fresh air system includes an environmental information sensor. The method includes:
receiving an air exhaust temperature sent by the air exhaust temperature sensor in real time;
in response to the air exhaust temperature being greater than a preset air exhaust temperature threshold, receiving environmental data sent by the environmental information sensor, and determining a heat dissipation mode based on the environmental data, in which the heat dissipation mode includes a fresh air mode, a refrigeration mode, and a heat pipe mode; and
controlling a heat dissipation system corresponding to the heat dissipation mode to dissipate heat from the cabinet, in which a heat dissipation system corresponding to the fresh air mode is a fresh air system, a heat dissipation system corresponding to the refrigeration mode is a refrigeration system, and a heat dissipation system corresponding to the heat pipe mode is a heat pipe system.

Optionally, the environmental information sensor includes an outdoor temperature sensor, an outdoor air particulate matter sensor and an air supply humidity sensor; in which receiving the environmental data sent by the environmental information sensor and determining the heat dissipation mode based on the environmental data includes:
receiving an outdoor temperature sent by the outdoor temperature sensor and calculating a temperature difference between the outdoor temperature and a preset temperature;
determining that the heat dissipation mode is the refrigeration mode in a case that the temperature difference is less than or equal to a preset temperature difference threshold;
receiving an air particulate matter concentration value sent by the outdoor air particulate matter sensor in a case that the temperature difference is greater than the preset temperature difference threshold;
determining that the heat dissipation mode is the heat pipe mode in a case that the air particulate matter concentration value is less than or equal to a preset particulate matter concentration threshold;
receiving air supply humidity sent by the air supply humidity sensor in a case that the air particulate matter concentration value is greater than the preset particulate matter concentration threshold; and
determining that the heat dissipation mode is the fresh air mode in a case that the air supply humidity is less than or equal to a preset humidity threshold; and determining that the heat dissipation mode is the heat pipe mode in a case that the air supply humidity is greater than the preset humidity threshold.

Optionally, the computer room fresh air system further includes an air inlet device and an air exhaust device, in which the air inlet device includes a first fan, and the air exhaust device includes a third fan; in which controlling the heat dissipation system corresponding to the heat dissipation mode to dissipate heat from the cabinet includes:
controlling the computer room fresh air system to turn on the first fan in a case that the heat dissipation mode is the fresh air mode; and
controlling the computer room fresh air system to turn on the third fan to dissipate heat from the cabinet after the first fan is turned on for a preset time period, in which a rotational speed of the first fan and a rotational speed of the third fan are the same.

Optionally, the air inlet device further includes a second fan, a filter and an air supply pressure sensor, in which after controlling the computer room fresh air system to turn on the third fan to dissipate heat from the cabinet after the first fan is turned on for the preset time period, the method including:
receiving an air supply pressure value sent by the air supply pressure sensor; and
controlling the computer room fresh air system to turn on the second fan to clean the filter in a case that the air supply pressure value is less than a preset air supply pressure threshold.

Optionally, the system for computer room temperature control further including a power supply system, in which the refrigeration system is powered by alternating current, and the fresh air system and the heat pipe system are powered by direct current; in which receiving the environmental data sent by the environmental information sensor in response to the air exhaust temperature being greater than the preset air exhaust temperature threshold and determining the heat dissipation mode based on the environmental data includes:
detecting whether the power supply system provides alternating current in response to the air exhaust temperature being greater than the preset air exhaust temperature threshold; and
receiving the environmental data sent by the environmental information sensor in a case that the power supply system does not provide alternating current, and determining the heat dissipation mode based on the environmental data, in which the heat dissipation mode includes a fresh air mode and a heat pipe mode.

A computer room fresh air system is further provided in the disclosure. The system includes an air inlet device, in which the air inlet device includes a first fan, a second fan, and a filter.

The first fan is configured to supply air to a computer room;
the second fan is configured to clean the filter; and
the filter is configured to filter particulate matters in the air.

Optionally, the air inlet device is equipped with an air inlet, an air outlet, an air inlet zone, a filtration zone, and an air outlet zone, in which the filtration zone is a middle location zone of the air inlet device, the air inlet zone is a location zone between the air inlet and the filtration zone, and the air outlet zone is a location zone between the air outlet and the filtration zone.

The filter includes a mesh filter, a coarse filter and a medium-efficiency filter. The first fan is arranged at the air inlet zone. The second fan is arranged at the air outlet zone. The mesh filter is arranged at the air inlet. The coarse filter and the medium-efficiency filter are arranged at the filtration zone, and the coarse filter is closer to the air inlet zone than the medium-efficiency filter.

The mesh filter is configured to perform preliminary filtration of the particulate matters in the air; the coarse filter is configured to perform further filtration of the particulate matters filtered by the mesh filter; and the medium-efficiency filter is configured to perform further filtration of the particulate matters filtered by the coarse filter.

Optionally, the air inlet device further includes an air supply pressure sensor, and the air supply pressure sensor is arranged at the air outlet zone.

The air supply pressure sensor is configured to monitor an air supply pressure value and control the second fan to rotate based on the air supply pressure value to clean the filter.

Optionally, the air inlet device further includes an outdoor temperature sensor, an outdoor air particulate matter sensor, and an air supply humidity sensor, in which the air supply humidity sensor is arranged at the air outlet zone, the outdoor temperature sensor and an outdoor air humidity sensor are arranged at a zone between the air inlet and the first fan.

The outdoor temperature sensor is configured to monitor an outdoor temperature;
the outdoor air particulate matter sensor is configured to monitor an outdoor air particulate matter concentration value; and
the air supply humidity sensor is configured to monitor air supply humidity.

An apparatus for computer room temperature control is further provided in the disclosure. The apparatus includes:
a receiving module, configured to receive an air exhaust temperature sent by an air exhaust temperature sensor in real time;
a determining module, configured to receive environmental data sent by an environmental information sensor in response to the air exhaust temperature being greater than a preset air exhaust temperature threshold, and determine a heat dissipation mode based on the environmental data, in which the heat dissipation mode includes a fresh air mode, a refrigeration mode, and a heat pipe mode; and
a heat dissipation module, configured to control a heat dissipation system corresponding to the heat dissipation mode to dissipate heat from a cabinet, in which a heat dissipation system corresponding to the fresh air mode is a fresh air system, a heat dissipation system corresponding to the refrigeration mode is a refrigeration system, and a heat dissipation system corresponding to the heat pipe mode is a heat pipe system.

A device for computer room temperature control is further provided in the disclosure. The device includes: a processor, and a memory storing a program for implementing a method for computer room temperature control.

The memory is configured to store the program.

The processor is configured to execute the program to implement the steps of the method for computer room temperature control.

A storage medium is further provided in the disclosure. The storage medium stores a program for implementing a method for computer room temperature control that, when executed by a processor, implements the method for computer room temperature control.

A method and an apparatus for computer room temperature control, a device and a storage medium are provided in the disclosure. Compared to the related art, in which the computer room temperature cannot be autonomously adjusted, in the disclosure, the air exhaust temperature sent by the air exhaust temperature sensor is received in real time; in response to the air exhaust temperature is greater than the preset air exhaust temperature threshold, environmental data sent by the environmental information sensor is received, and the heat dissipation mode is determined based on the environmental data, in which the heat dissipation mode includes a fresh air mode, a refrigeration mode, and a heat pipe mode; and the heat dissipation system corresponding to the heat dissipation mode is controlled to dissipate heat from the cabinet, in which a heat dissipation system corresponding to the fresh air mode is a fresh air system, a heat dissipation system corresponding to the refrigeration mode is a refrigeration system, and a heat dissipation system corresponding to the heat pipe mode is a heat pipe system. In the disclosure, when the air exhaust temperature of the cabinet is too high, an appropriate heat dissipation system is selected from the preset fresh air system, refrigeration system, and heat pipe system based on the current environmental data to dissipate heat from the cabinet, which can adapt to complex environmental changes, with strong adaptability, and thus improving the energy-saving efficiency of the system for communication computer room temperature control.

### BRIEF DESCRIPTION OF THE DRAWINGS

The drawings herein are incorporated into the specification and constitute a part of the specification, showing embodiments that conform to the disclosure, and are used together with the specification to explain the principles of the embodiments of the disclosure. In order to more clearly illustrate the technical solutions of the embodiments of the disclosure or the technical solutions of the related art, the drawings used in the description of the embodiments of the disclosure or the related art may be briefly introduced below. Obviously, for those skilled in the art, other drawings can be obtained based on these drawings without creative works.
FIG. 1 is a block diagram illustrating a device architecture of a hardware operating environment according to an embodiment of the disclosure.
FIG. 2 is a flow chart illustrating a method for computer room temperature control according to an embodiment of the disclosure.
FIG. 3 is a block diagram illustrating modules of an apparatus for computer room temperature control according to an embodiment of the disclosure.
FIG. 4 is a schematic diagram illustrating a main view of a computer room of a system for computer room temperature control according to an embodiment of the disclosure.
FIG. 5 is a schematic diagram illustrating a top view of a computer room of a system for computer room temperature control according to an embodiment of the disclosure.
FIG. 6 is a block diagram illustrating an architecture of an air inlet device of a system for computer room temperature control according to an embodiment of the disclosure.
FIG. 7 is a schematic diagram illustrating an interaction in a method for computer room temperature control according to an embodiment of the disclosure.

The implementation, functional features and advantages of the disclosure will be further described in conjunction with the embodiments and with reference to the accompanying figures.

### DETAILED DESCRIPTION

It should be understood that the specific embodiments described herein are intended only to explain the disclosure and are not intended to limit the disclosure.

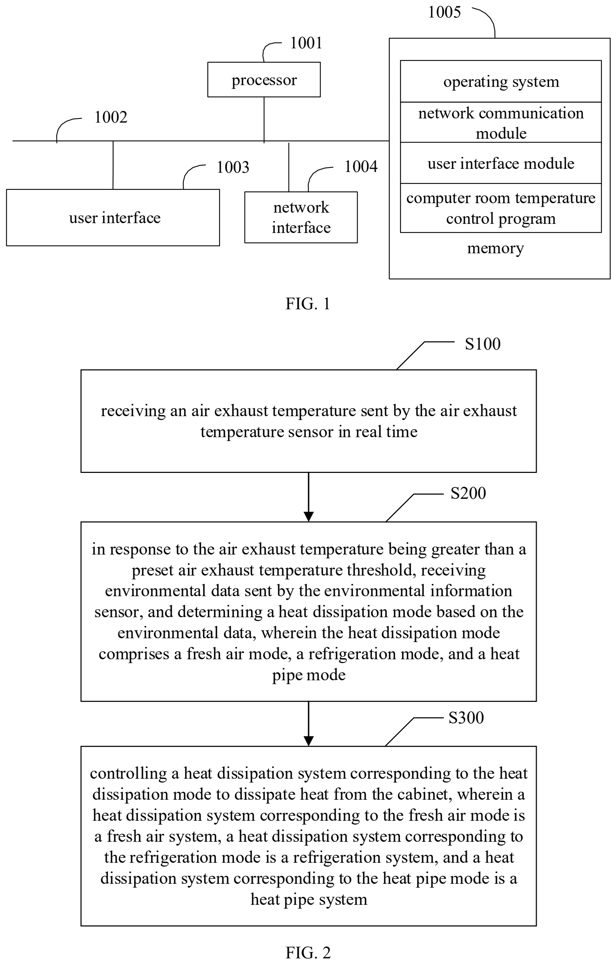

As shown in FIG. 1, it is a block diagram illustrating a device architecture of a hardware operating environment involved in an embodiment of the disclosure.

A terminal in embodiments of the disclosure can be a personal computer (PC), or a portable terminal device with a display function, such as a smartphone, a tablet, an e-reader, a moving picture experts group audio layer III (MP3) player, a moving picture experts group audio layer IV (MP4) player, a portable computer, and so on.

As shown in FIG. 1, the terminal may include: a processor 1001, such as a central processing unit (CPU), a network interface 1004, a user interface 1003, a memory 1005, and a communication bus 1002. The communication bus 1002 is configured to implement connection communication between the components. The user interface 1003 may include a display, an input unit such as a keyboard. Optionally, the user interface 1003 may also include a standard wired interface or a wireless interface. Optionally, the network interface 1004 may include a standard wired interface or a wireless interface (such as WI-FI interface). The memory 1005 may be a high-speed random access memory (RAM) memory or a non-volatile memory, such as a disk memory. Optionally, the memory 1005 may also be a storage device independent of the processor 1001.

Optionally, the terminal may also include a camera, a radio frequency (RF) circuit, a sensor, an audio circuitry, a WiFi module, and so on. The sensor can include a light sensor, a motion sensor, and other types of sensors. In particular, the light sensor may include an ambient light sensor and a proximity sensor. The ambient light sensor can adjust brightness of the display according to the intensity of the surrounding light. The proximity sensor can turn off the display and/or the backlight when the mobile terminal is moved to the ear. As an example of the motion sensor, the gravity acceleration sensor can detect the magnitude of acceleration in various directions (generally three axes). When stationary, the gravity acceleration sensor can detect the magnitude and direction of gravity, which can be used in applications for recognizing the posture of the mobile terminal (such as screen orientation switching, related games, or calibration of a magnetometer), functions related to vibration detection (such as pedometers or tapping gestures), and so on. Additionally, the mobile terminal can also be equipped with other sensors such as a gyroscope, a barometer, a hygrometer, a thermometer, an infrared sensor, and so on, which will not be repeated here.

It can be understood by those skilled in the art that the terminal structure illustrated in FIG. 1 does not constitute a limitation of the terminal, and the terminal may include more or fewer components than illustrated, or a combination of certain components, or a different arrangement of components.

As shown in FIG. 1, the memory 1005, as a computer storage medium, may include an operating device, a network communication module, a user interface module, and a computer room temperature control program.

In the terminal shown in FIG. 1, the network interface 1004 is configured to connect to a backend server and perform data communication with the backend server. The user interface 1003 is configured to connect to a client (user equipment)) and perform data communication with the client. The processor 1001 may be configured to call the computer room temperature control program stored in the memory 1005.

Referring to FIG. 2, a method for computer room temperature control is provided in an embodiment of the disclosure. The method is executed by an apparatus for computer room temperature control in a system for computer room temperature control. The system includes a computer room fresh air system, a computer room, a cabinet ventilation system, a refrigeration system and a heat pipe system. The cabinet ventilation system includes a cabinet and an air exhaust temperature sensor. The computer room fresh air system includes an environmental information sensor. The method includes the following steps.

At step S100, an air exhaust temperature sent by the air exhaust temperature sensor is received in real time.

At step S200, in response to the air exhaust temperature being greater than a preset air exhaust temperature threshold, environmental data sent by the environmental information sensor is received, and a heat dissipation mode is determined based on the environmental data, in which the heat dissipation mode includes a fresh air mode, a refrigeration mode, and a heat pipe mode.

At step S300, a heat dissipation system corresponding to the heat dissipation mode is controlled to dissipate heat from the cabinet, in which a heat dissipation system corresponding to the fresh air mode is a fresh air system, a heat dissipation system corresponding to the refrigeration mode is a refrigeration system, and a heat dissipation system corresponding to the heat pipe mode is a heat pipe system.

In this embodiment, the application scenario being addressed may be as follows.

For example, a scenario of computer room temperature control may be as following. In a communication computer room, devices operate continuously throughout the entire year, the power consumption of the devices continues to increase as the service volume grows, leading to a increasingly obvious problem of high energy consumption for cooling the computer room. As a result, the energy efficiency of the computer room is generally low. To reduce energy consumption, the related art usually adopts a fresh air technology or a heat exchange technology for heat dissipation of the devices in the communication computer room. However, both the fresh air technology and the heat exchange technology have the following limitations. For the fresh air system, it can only be used in the time period when the outdoor air quality is good and the air humidity is low. If the above conditions are not met, problems such as system fouling, which reduces heat dissipation efficiency, and excessive humidity in the computer room may arise. For the heat pipe system, it can only be used in the time period when the temperature difference between indoor and outdoor air is significant, otherwise the heat dissipation efficiency is low. Thus, the above methods are only effective during certain periods of the year, and cannot adapt to the complex environmental changes throughout the entire year or autonomously adjust the computer room temperature, resulting in a low energy-saving efficiency of the system for communication computer room temperature control. For this scenario, in the disclosure, when the air exhaust temperature of the cabinet is too high, an appropriate heat dissipation system is selected from the preset fresh air system, refrigeration system, and heat pipe system based on the current environmental data to dissipate heat from the cabinet, which can adapt to complex environmental changes, with strong adaptability, and thus improving the energy-saving efficiency of the system for communication computer room temperature control.

For example, the application scenario of the computer room temperature control is not limited to the communication computer room, but also includes various types of data centers, computer rooms, and so on, which is not limited herein.

The purpose of the disclosure is to enable the system for computer room temperature control to adapt to complex environmental changes, and to improve the energy-saving efficiency of the system for communication computer room temperature control.

The specific steps are as follows.

The method for computer room temperature control is executed by an apparatus for computer room temperature control in a system for computer room temperature control. The system includes a computer room fresh air system, a computer room, a cabinet ventilation system, a refrigeration system and a heat pipe system. The cabinet ventilation system includes a cabinet and an air exhaust temperature sensor. The computer room fresh air system includes an environmental information sensor.

At step S100, an air exhaust temperature sent by the air exhaust temperature sensor is received in real time.

In an embodiment, the air exhaust temperature sensor is arranged at the cabinet ventilation system and is configured to obtain the air exhaust temperature of the cabinet when discharging hot air. The cabinet ventilation system further includes an exhaust fan, which can exhaust the hot air from inside the cabinet to the outside. The exhaust fan is a direct current fan with an adjustable rotational speed. The exhaust fan is equipped with a built-in temperature sensor for monitoring the air exhaust temperature of the cabinet. The air exhaust temperature sensor is communicatively connected to the device. The air exhaust temperatures of all the cabinets can reach Tᵢₙₙₑᵣ by adjusting the rotational speed of the exhaust fan. Tᵢₙₙₑᵣ is a self-set temperature threshold, which can be manually adjusted. For example, if the air exhaust temperatures of three cabinets are Tₐ, T_{b}, and T_{c} respectively, an exhaust air temperature when the exhaust fan A is running is Ta. If Tₐ < Tᵢₙₙₑᵣ, the rotational speed of the exhaust fan is increased. If Tₐ > Tᵢₙₙₑᵣ, the rotational speed of the exhaust fan is reduced. The exhaust fans of other cabinets can be adjusted in the same way, to make Tₐ = T_{b} = T_{c} = Tᵢₙₙₑᵣ.

In an embodiment, the cabinet ventilation system is introduced to allow the heat to be more easily exhausted from the cabinet, thus reducing the limits of the heat dissipation system and extending the duration of utilizing the natural refrigeration.

At step S200, in response to the air exhaust temperature being greater than a preset air exhaust temperature threshold, environmental data sent by the environmental information sensor is received, and a heat dissipation mode is determined based on the environmental data, in which the heat dissipation mode includes a fresh air mode, a refrigeration mode, and a heat pipe mode.

In an embodiment, if the air exhaust temperature is greater than the preset air exhaust temperature threshold, it indicates that the temperature inside the current cabinet is too high during the operation of the device, and heat dissipation is required, thus the system for computer room temperature control is activated. If the air exhaust temperature is less than or equal to the preset air exhaust temperature threshold, the system for computer room temperature control is in a standby mode.

In an embodiment, after the system for computer room temperature control is activated, the apparatus receives the environmental data sent by the environmental information sensor. The environmental data includes, but is not limited to the outdoor temperature, the outdoor air particulate matter concentration value, and the air supply humidity.

In an embodiment, the heat dissipation modes set under the system for computer room temperature control include the fresh air mode, the refrigeration mode, and the heat pipe mode. The apparatus determines the heat dissipation mode based on the environmental data. That is, it selects an appropriate refrigeration mode for different environmental data to adapt to complex environmental changes. Thus, the adaptability of the system is enhanced, and the energy-saving efficiency of the system for communication computer room temperature control is further improved. The fresh air mode is to directly suck low-temperature air from outdoor into the computer room, cool the environment inside the computer room, and then blow out the hot air. The heat pipe mode integrates a split-type heat pipe into the traditional computer room air conditioning. When the indoor hot air flows through the indoor unit of the heat pipe, the refrigerant inside the heat pipe undergoes a phase change process, transferring the heat to the outdoor unit. The outdoor cold air cools down the outdoor unit, thus transferring the heat from indoors to outdoors. The refrigeration mode adopts the traditional voltage-based cooling of the computer room air conditioning.

The step S200 includes the following steps S210 to S260.

The environmental information sensor includes an outdoor temperature sensor, an outdoor air particulate matter sensor and an air supply humidity sensor.

At step S210, an outdoor temperature sent by the outdoor temperature sensor is received and a temperature difference between the outdoor temperature and a preset temperature is calculated.

At step S220, it is determined whether the temperature difference is less than or equal to a preset temperature difference threshold. The heat dissipation mode is determined to be the refrigeration mode in a case that the temperature difference is less than or equal to the preset temperature difference threshold.

At step S230, an air particulate matter concentration value sent by the outdoor air particulate matter sensor is received in a case that the temperature difference is greater than the preset temperature difference threshold.

At step S240, it is determined whether the air particulate matter concentration value is less than or equal to a preset particulate matter concentration threshold. The heat dissipation mode is determined to be the heat pipe mode in a case that the air particulate matter concentration value is less than or equal to the preset particulate matter concentration threshold.

At step S250, air supply humidity sent by the air supply humidity sensor is received in a case that the air particulate matter concentration value is greater than the preset particulate matter concentration threshold.

At step S260, it is determined whether the air supply humidity is less than or equal to a preset humidity threshold. The heat dissipation mode is determined to be the fresh air mode in a case that the air supply humidity is less than or equal to a preset humidity threshold. The heat dissipation mode is determined to be the heat pipe mode in a case that the air supply humidity is greater than the preset humidity threshold.

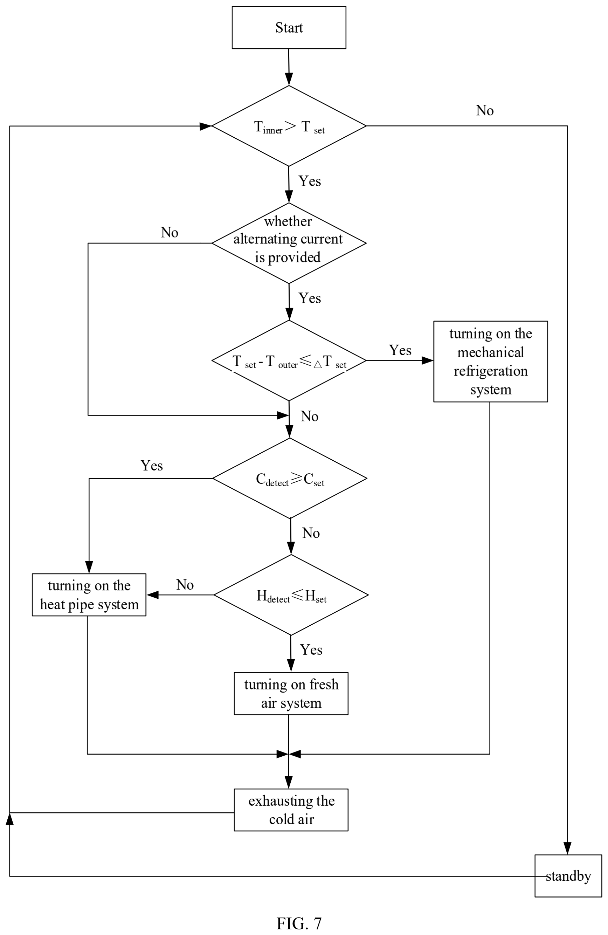

In an embodiment, referring to FIG. 7, when the air exhaust temperature is greater than the preset air exhaust temperature threshold, the apparatus detects a temperature difference between a set temperature and the outdoor air temperature. If *T*ₛₑₜ *- Tₒᵤₜₑᵣ* ≤ Δ*Tₛₑₜ,* the refrigeration mode is activated, a mechanical refrigeration system is turned on, and Δ*T*ₛₑₜ can be adjusted manually, otherwise, the next step of judgment is performed.

Further, the outdoor air particulate matter concentration value is detected. If *C*_{detect} ≤ *C*ₛₑₜ, the heat pipe mode is activated and the heat pipe system is turned on, otherwise, the next step of judgment is performed.

Further, the air supply humidity is detected. If *H*_{detect} ≤ *H*ₛₑₜ, the fresh air mode is activated, and the computer room fresh air system is turned on, otherwise, the heat pipe mode is activated, and the heat pipe system is turned on.

By activating the refrigeration mode, the heat pipe mode, and the fresh air mode and adjusting Tᵢₙₙₑᵣ, the magnitudes of Tᵢₙₙₑᵣ and Tₛₑₜ is compared again, and the above process is repeated.

At step S300, a heat dissipation system corresponding to the heat dissipation mode is controlled to dissipate heat from the cabinet, in which a heat dissipation system corresponding to the fresh air mode is a fresh air system, a heat dissipation system corresponding to the refrigeration mode is a refrigeration system, and a heat dissipation system corresponding to the heat pipe mode is a heat pipe system.

In an embodiment, the heat dissipation system corresponding to the fresh air mode is a fresh air system, the heat dissipation system corresponding to the refrigeration mode is the refrigeration system, and the heat dissipation system corresponding to the heat pipe mode is the heat pipe system. Each heat dissipation system is equipped with a corresponding hardware device, and the corresponding heat dissipation function is implemented by the hardware device. In particular, each of the refrigeration system and the heat pipe system is equipped with an indoor unit, an outdoor unit and a refrigerant pipe. The refrigeration system and the heat pipe system can be integrated into a single computer room air conditioning system, or they can be integrated separately. If the refrigeration system and the heat pipe system can be integrated into a single computer room air conditioning system, the refrigeration system and the heat pipe system can share one set of indoor unit and outdoor unit fan. The fans are direct current fans with adjustable rotational speed.

In an embodiment, the overall system for computer room temperature control consists of a computer room fresh air system, a refrigeration system, a heat pipe system, and a cabinet ventilation system. The subsystems are interconnected and work in coordination, regulated and controlled uniformly through the apparatus. This system can adapt to complex environmental changes, with a strong adaptability, thus improving the energy-saving efficiency of the system for communication computer room temperature control.

The step S300 includes the following steps S310 to S320.

The computer room fresh air system further includes an air inlet device and an air exhaust device. The air inlet device includes a first fan, a second fan, a filter and an air supply pressure sensor. The air exhaust device includes a third fan.

At step S310, the computer room fresh air system is controlled to turn on the first fan in a case that the heat dissipation mode is the fresh air mode.

In an embodiment, the apparatus controls the computer room fresh air system to turn on the first fan in a case that the heat dissipation mode is the fresh air mode. The first fan is a fan of the air inlet device in the computer room fresh air system and is configured to supply air to the computer room. After the first fan is turned on, the first fan supplies air to the computer room.

At step S320, the computer room fresh air system is controlled to turn on the third fan to dissipate heat from the cabinet after the first fan is turned on for a preset time period, in which a rotational speed of the first fan and a rotational speed of the third fan are the same.

In an embodiment, the incoming cold air may be quickly exhausted outside when the air inlet motor and the air exhaust motor are turned on simultaneously, thus a time period is set in the disclosure. The computer room fresh air system is controlled to turn on the third fan to dissipate heat from the cabinet after the first fan is turned on for a preset time period, and a rotational speed of the first fan and a rotational speed of the third fan are the same, thus making full use of the air cooling capacity.

At step S320, after controlling the computer room fresh air system to turn on the third fan to dissipate heat from the cabinet after the first fan is turned on for a preset time period, the method includes the following steps S330 to S340.

At step S330, an air supply pressure value sent by the air supply pressure sensor is received.

In an embodiment, the air inlet device is further equipped with an air supply pressure sensor. The air supply pressure sensor is configured to monitor an air supply pressure value. The apparatus is communicatively connected to the air supply pressure sensor. After turning on the air inlet motor, the apparatus receives the air supply pressure value sent by the air supply pressure sensor in real time.

At step S340, the computer room fresh air system is controlled to turn on a second fan to clean a filter in a case that the air supply pressure value is less than a preset air supply pressure threshold.

In an embodiment, the apparatus determines whether the air supply pressure value is less than the preset air supply pressure threshold. The computer room fresh air system is controlled to turn on the second fan to clean the filter in a case that the air supply pressure value is less than a preset air supply pressure threshold. In particular, when P_{detect} < Pₛₑₜ at an air supply pressure monitoring point , the second fan is turned on to blow air from indoors to outdoors, blowing out the dust inside the air inlet device to clean the filter, in which Pₛₑₜ can be set manually.

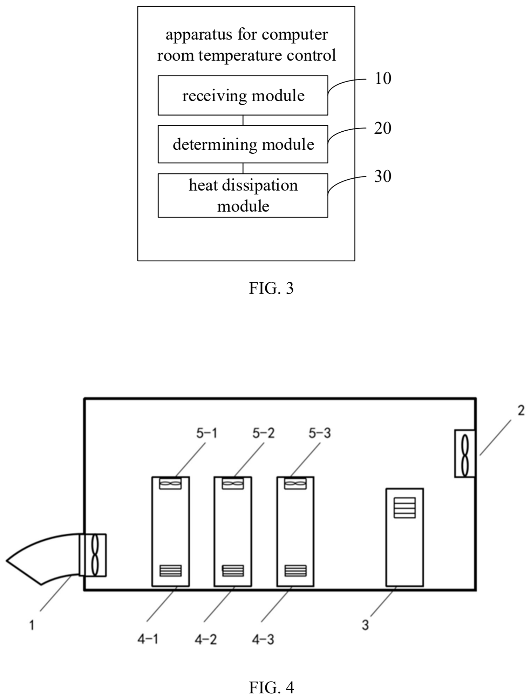

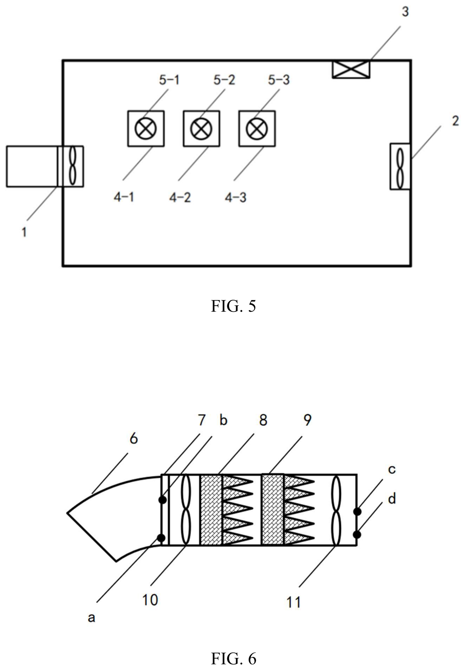

Referring to FIG. 4 and FIG. 5, a main view and a top view of a computer room of a system for computer room temperature control of the disclosure are shown. In particular, the computer room fresh air system includes the air inlet device 1 and the air exhaust device 2. The air inlet device includes a fan and a filtration system. The air exhaust device includes a fan and an air exhaust valve. The fans of the air inlet device 1 and the air exhaust device 2 have exactly the same rotational speed, air volume, and other parameters, and they are both direct current fans with adjustable rotational speed. The air exhaust valve of the air exhaust device 2 is closed when the fan is turned off, and the air exhaust valve of the air exhaust device 2 is opened when the fan is turned on. The cabinet ventilation system consists of a cabinet 4-1, a cabinet top fan 5-1. The cabinet top fan 5-1 can exhaust the hot air inside the cabinet to the outside. The exhaust fan is a direct current fan with adjustable rotational speed. The exhaust fan is equipped with a built-in temperature sensor to monitor the air exhaust temperature Tₐ of the cabinet. The computer room air conditioning system 3 integrates a mechanical refrigeration system with a heat pipe system, and consists of an indoor unit, an outdoor unit, and a refrigerant pipe. The mechanical refrigeration system and the heat pipe system can be operated separately. The mechanical refrigeration system and the heat pipe system share one set of indoor unit and outdoor unit fan. The fan is a direct current fan with adjustable rotational speed. The overall temperature control system can set manually a temperature threshold Tₛₑₜ, a PM10 threshold Cₛₑₜ of the computer room fresh air system, air humidity threshold Hₛₑₜ of the computer room fresh air system.

In an embodiment, the fans of the system are all direct current fans, whose rotational speed can be adjusted based on the heat generated by the devices, thus greatly reducing the energy consumption of the fans.

In an embodiment, when the computer room fresh air system is turned on, the air inlet device and the air exhaust device are activated. By using positive pressure air supply and negative pressure air suction, the cold and hot air within the computer room are orderly guided, avoiding the problem of airflow short circuit airflow, and improving the heat dissipation efficiency.

A method for computer room temperature control is provided in the disclosure. Compared to the related art, in which the computer room temperature cannot be autonomously adjusted, in the disclosure, the air exhaust temperature sent by the air exhaust temperature sensor is received in real time; in response to the air exhaust temperature being greater than the preset air exhaust temperature threshold, environmental data sent by the environmental information sensor is received, and the heat dissipation mode is determined based on the environmental data, in which the heat dissipation mode includes a fresh air mode, a refrigeration mode, and a heat pipe mode; and the heat dissipation system corresponding to the heat dissipation mode is controlled to dissipate heat from the cabinet, in which a heat dissipation system corresponding to the fresh air mode is a fresh air system, a heat dissipation system corresponding to the refrigeration mode is a refrigeration system, and a heat dissipation system corresponding to the heat pipe mode is a heat pipe system. In the disclosure, when the air exhaust temperature of the cabinet is too high, an appropriate heat dissipation system is selected from the preset fresh air system, refrigeration system, and heat pipe system based on the current environmental data to dissipate heat from the cabinet, which can adapt to complex environmental changes, with strong adaptability, and thus improving the energy-saving efficiency of the system for communication computer room temperature control.

Based on the first embodiment described above, another embodiment is provided in the disclosure. The method for computer room temperature control includes the following steps.

The step S200, in which in response to the air exhaust temperature being greater than a preset air exhaust temperature threshold, receiving environmental data sent by the environmental information sensor, and determining a heat dissipation mode based on the environmental data includes the following steps A100 to A300.

The system for computer room temperature control further includes a power supply system. The refrigeration system is powered by alternating current. The fresh air system and the heat pipe system are powered by direct current.

At step A100, it is detected whether the power supply system provides alternating current in response to the air exhaust temperature being greater than the preset air exhaust temperature threshold.

In an embodiment, the method for the apparatus to monitor whether the real-time power supply system raises alternating current may be detecting an alternating current input value of the power supply system, thus the status of the alternating current power supply may be determined. The refrigeration system is powered by alternating current, and the fresh air system and the heat pipe system are powered by direct current. In particular, the overall temperature control system is powered by both alternating current and direct current. A compressor of the refrigeration system is powered by alternating current. The fans of the refrigeration system and the heat pipe system, the computer room fresh air system, and the cabinet ventilation system are powered by direct current.

At step A200, the environmental data sent by the environmental information sensor is received in a case that the power supply system does not provide alternating current, and the heat dissipation mode is determined based on the environmental data, in which the heat dissipation mode includes a fresh air mode and a heat pipe mode.

In an embodiment, when the power supply system does not provide alternating current, i.e., when the mains electricity is interrupted and no alternating current is supplied, the refrigeration system cannot be started, and only the heat pipe system, the computer room fresh air system, and the cabinet ventilation system of the computer room air conditioning system can be started. Thus, selection may be made between the fresh air mode and the heat pipe mode only, to solve the problem of device overheating caused by the cessation of cooling in the computer room when the mains electricity is interrupted and the power is unable to be provided.

At step A300, the environmental data sent by the environmental information sensor is received in a case that the power supply system provides alternating current, and the heat dissipation mode is determined based on the environmental data, in which the heat dissipation mode includes the fresh air mode, the refrigeration mode and the heat pipe mode.

In an embodiment, if the power supply system provides alternating current, the refrigeration system also operates normally, and thus the same steps as that in S200 can be performed.

A computer room fresh air system is further provided in the disclosure. The system includes an air inlet device, in which the air inlet device includes a first fan, a second fan, and a filter.

The first fan is configured to supply air to a computer room;
the second fan is configured to clean the filter; and
the filter is configured to filter particulate matters in the air.

In particular, the air inlet device is equipped with an air inlet, an air outlet, an air inlet zone, a filtration zone, and an air outlet zone, in which the filtration zone is a middle location zone of the air inlet device, the air inlet zone is a location zone between the air inlet and the filtration zone, and the air outlet zone is a location zone between the air outlet and the filtration zone.

The filter includes a mesh filter, a coarse filter and a medium-efficiency filter. The first fan is arranged at the air inlet zone. The second fan is arranged at the air outlet zone. The mesh filter is arranged at the air inlet. The coarse filter and the medium-efficiency filter are arranged at the filtration zone, in which the coarse filter is closer to the air inlet zone than the medium-efficiency filter.

The mesh filter is configured to perform preliminary filtration of the particulate matters in the air;
the coarse filter is configured to perform further filtration of the particulate matters filtered by the mesh filter; and
the medium-efficiency filter is configured to perform further filtration of the particulate matters filtered by the coarse filter.

In particular, the air inlet device further includes an air supply pressure sensor, and the air supply pressure sensor is arranged at the air outlet zone.

The air supply pressure sensor is configured to monitor an air supply pressure value and control the second fan to rotate based on the air supply pressure value to clean the filter.

In particular, the air inlet device further includes an outdoor temperature sensor, an outdoor air particulate matter sensor, and an air supply humidity sensor, in which the air supply humidity sensor is arranged at the air outlet zone, in which the outdoor temperature sensor and an outdoor air humidity sensor are arranged at a zone between the air inlet and the first fan.

The outdoor temperature sensor is configured to monitor an outdoor temperature; the outdoor air particulate matter sensor is configured to monitor an outdoor air particulate matter concentration value; the air supply humidity sensor is configured to monitor air supply humidity.

Referring to FIG. 6, the air inlet device further includes a rain cover 6, a mesh filter 7, a coarse filter 8, a medium-efficiency filter 9, a first fan A 10, and a second fan B 11. As shown in FIG. 6, point a is an outdoor temperature monitoring point, and a temperature value monitored at point a is Tₒᵤₜₑᵣ. Point b is an outdoor air PM10 monitoring point, and a PM10 value monitored at point b is C_{detect}. Point c is an air supply humidity monitoring point, and a air humidity value monitored at point c is H_{detect}. Point d is an air supply pressure monitoring point, and a pressure value monitored at point d is P_{detect}. When the air inlet device 1 is turned on, the first fan A 10 is activated to supply air from the outdoors to the indoors. When it detects P_{detect} < Pₛₑₜ at the air supply pressure monitoring point d, the second fan B 11 is turned on to blow air from indoors to outdoors, blowing dust out from the air inlet device 1, in which Pₛₑₜ can be set manually.

In an embodiment, the air inlet pressure is monitored to detect fouling, and the dust is removed by blowing in reverse, so that there is no need for the user to manually clean the dust, thus maintaining the cleanliness of the air inlet, and further improving the heat dissipation effect.

An apparatus for computer room temperature control is further provided in the disclosure. As shown in FIG. 3, the apparatus includes a receiving module 10, a determining module 20 and a heat dissipation module 30.

The receiving module 10 is configured to receive an air exhaust temperature sent by an air exhaust temperature sensor in real time.

The determining module 20 is configured to receive environmental data sent by an environmental information sensor in response to the air exhaust temperature being greater than a preset air exhaust temperature threshold, and determine a heat dissipation mode based on the environmental data, in which the heat dissipation mode includes a fresh air mode, a refrigeration mode, and a heat pipe mode.

The heat dissipation module 30 is configured to control a heat dissipation system corresponding to the heat dissipation mode to dissipate heat from a cabinet, in which a heat dissipation system corresponding to the fresh air mode is a fresh air system, a heat dissipation system corresponding to the refrigeration mode is a refrigeration system, and a heat dissipation system corresponding to the heat pipe mode is a heat pipe system.

Optionally, the determining module 20 includes an outdoor temperature receiving module, a refrigeration mode determining module, an air particulate matter concentration value receiving module, a heat pipe mode determining module, an air supply humidity receiving module and a fresh air mode determining module.

The outdoor temperature receiving module is configured to receive an outdoor temperature sent by the outdoor temperature sensor and calculate a temperature difference between the outdoor temperature and a preset temperature.

The refrigeration mode determining module is configured to determine whether the temperature difference is less than or equal to a preset temperature difference threshold, and determine that the heat dissipation mode is the refrigeration mode in a case that the temperature difference is less than or equal to the preset temperature difference threshold.

The air particulate matter concentration value receiving module is configured to receive an air particulate matter concentration value sent by the outdoor air particulate matter sensor in a case that the temperature difference is greater than the preset temperature difference threshold.

The heat pipe mode determining module is configured to determine whether the air particulate matter concentration value is less than or equal to a preset particulate matter concentration threshold, and determine that the heat dissipation mode is the heat pipe mode in a case that the air particulate matter concentration value is less than or equal to a preset particulate matter concentration threshold.

The air supply humidity receiving module is configured to receive the air supply humidity sent by the air supply humidity sensor in a case that the air particulate matter concentration value is greater than the preset particulate matter concentration threshold.

The fresh air mode determining module is configured to determine whether the air supply humidity is less than or equal to a preset humidity threshold, determine that the heat dissipation mode is the fresh air mode in a case that the air supply humidity is less than or equal to a preset humidity threshold; and determine that the heat dissipation mode is the heat pipe mode in a case that the air supply humidity is greater than the preset humidity threshold.

Optionally, the heat dissipation module 30 includes a fresh air mode activating module and a fresh air system heat dissipation module.

The fresh air mode activating module is configured to control the computer room fresh air system to turn on the first fan in a case that the heat dissipation mode is the fresh air mode.

The fresh air system heat dissipation module is configured to control the computer room fresh air system to turn on the third fan to dissipate heat from the cabinet after the first fan is turned on for a preset time period, in which a rotational speed of the first fan and a rotational speed of the third fan are the same.

Optionally, the heat dissipation module 30 further includes an air supply pressure value receiving module and a cleaning module.

The air supply pressure value receiving module is configured to receive an air supply pressure value sent by the air supply pressure sensor.

The cleaning module is configured to determine whether the air supply pressure value is less than a preset air supply pressure threshold, and control the computer room fresh air system to turn on the second fan to clean the filter in a case that the air supply pressure value is less than the preset air supply pressure threshold.

Optionally, the determining module 20 further includes an alternating current detecting module and a heat dissipation mode determining module.

The alternating current detecting module is configured to detect whether the power supply system provides alternating current in response to the air exhaust temperature being greater than the preset air exhaust temperature threshold.

The heat dissipation mode determining module is configured to receive the environmental data sent by the environmental information sensor in a case that the power supply system does not provide alternating current, and determine the heat dissipation mode based on the environmental data, in which the heat dissipation mode includes a fresh air mode and a heat pipe mode.

The specific implementation of the apparatus for computer room temperature control of the disclosure is basically the same as the above embodiments of the method for computer room temperature control, which will not be repeated here.

As shown in FIG. 1, it is a block diagram illustrating an architecture of a device of a hardware operating environment involved in an embodiment of the disclosure.

As shown in FIG. 1, the terminal may include: a processor 1001, such as a central processing unit (CPU), a network interface 1004, a user interface 1003, a memory 1005, and a communication bus 1002. The communication bus 1002 is configured to implement connection and communication between the components. The user interface 1003 may include a display, and an input unit such as a keyboard. Optionally, the user interface 1003 may also include a standard wired interface or a wireless interface. Optionally, the network interface 1004 may include a standard wired interface or a wireless interface (such as WI-FI interface). The memory 1005 may be a high-speed random access memory (RAM) memory or a non-volatile memory, such as a disk memory. Optionally, the memory 1005 may also be a storage device independent of the processor 1001.

Optionally, the apparatus for computer room temperature control may also include a rectangular user interface, a network interface, a camera, a radio frequency (RF) circuit, a sensor, an audio circuitry, a WiFi module, and so on. The rectangular user interface may include a display, an input submodule such as a keyboard, and optionally, the rectangular user interface may include a standard wired interface and a wireless interface. Optionally, the network interface may include a standard wired interface and a wireless interface (e.g., WI-FI interface).

It can be understood by those skilled in the art that the apparatus structure illustrated in FIG. 1 does not constitute a limitation of the apparatus, and may include more or fewer components than illustrated, or a combination of certain components, or a different arrangement of components.

As shown in FIG. 1, the memory 1005, as a computer storage medium, may include an operating system, a network communication module and a computer room temperature control program. The operating system is a program that manages and controls the hardware and software resources of the apparatus for computer room temperature control, to support the operation of the computer room temperature control program and other software and/or programs. The network communication module is configured to enable communication between components within the memory 1005 and communication with other hardware and software in the system for computer room temperature control.

As shown in FIG. 1, in the apparatus for computer room temperature control, the processor 1001 is configured to execute the program for computer room temperature control stored in the memory 1005 to implement the steps of the method for computer room temperature control described in any of the above embodiments.

The specific implementation of the apparatus for computer room temperature control of the disclosure is basically the same as the above embodiments of the method for computer room temperature control, which will not be repeated here.

A storage medium is further provided in the disclosure. The storage medium stores a program for implementing a method for computer room temperature control that, when executed by a processor, implements the method for computer room temperature control.

The specific implementation of the storage medium of the disclosure is basically the same as the above embodiments of the method for computer room temperature control, which will not be repeated here.

A computer program product is further provided in the disclosure. The computer program product includes a computer program that, when executed by a processor, implements the method for computer room temperature control described above.

The specific implementation of the computer program product of the disclosure is basically the same as the above embodiments of the method for computer room temperature control, which will not be repeated here.

It should be noted that, the terms "include/including", "contain/containing" or any other variations thereof, are intended to cover a non-exclusive inclusion, such that a process, a method, an article or an apparatus including a series of elements not only includes those elements but also includes other elements not expressly listed, or may also include elements inherent to such process, method, article, or apparatus. In the absence of more limitations, the element defined by a sentence "including one" do not preclude the presence of additional same elements in the process, method, article, or apparatus that includes the elements.

The above serial numbers of embodiments of the disclosure are for descriptive purposes only and do not represent the merits of the embodiments.

Through the description of the implementations above, those skilled in the art can clearly understand that the aforementioned embodiments of the method can be realized by utilizing software along with the necessary general hardware platform. It can also be implemented through hardware; however, in many cases, the former is the preferred approach. On the basis of such understanding, the essence of the technical solution of the present disclosure or part of the technical solution contributing to the prior art may be embodied in the form of a software product, which is stored in the storage medium described above (e.g., ROM/RAM, disk, CD-ROM), including several instructions configured to enable a terminal device (which may be a cell phone, a computer, a server, an air conditioner, or a network device, etc.) to perform the method described in various embodiments of the disclosure.

The above is only preferred embodiments of the disclosure and does not limit the scope of the disclosure. Any equivalent structures or processes that are derived from the content of the description and accompanying drawings of the disclosure, or that are applied directly or indirectly in other related technical fields, are similarly included within the protection scope of the present invention.

## Claims

1. A method for computer room temperature control, wherein the method is executed by an apparatus for computer room temperature control in a system for computer room temperature control, the system comprises a computer room fresh air system, a computer room, a cabinet ventilation system, a refrigeration system and a heat pipe system, wherein the cabinet ventilation system comprises a cabinet and an air exhaust temperature sensor, and the computer room fresh air system comprises an environmental information sensor; wherein the method comprising:
receiving an air exhaust temperature sent by the air exhaust temperature sensor in real time;
in response to the air exhaust temperature being greater than a preset air exhaust temperature threshold, receiving environmental data sent by the environmental information sensor, and determining a heat dissipation mode based on the environmental data, wherein the heat dissipation mode comprises a fresh air mode, a refrigeration mode, and a heat pipe mode; and
controlling a heat dissipation system corresponding to the heat dissipation mode to dissipate heat from the cabinet, wherein a heat dissipation system corresponding to the fresh air mode is a fresh air system, a heat dissipation system corresponding to the refrigeration mode is a refrigeration system, and a heat dissipation system corresponding to the heat pipe mode is a heat pipe system.

2. The method according to claim 1, wherein the environmental information sensor comprises an outdoor temperature sensor, an outdoor air particulate matter sensor and an air supply humidity sensor; wherein receiving the environmental data sent by the environmental information sensor and determining the heat dissipation mode based on the environmental data comprises:
receiving an outdoor temperature sent by the outdoor temperature sensor and calculating a temperature difference between the outdoor temperature and a preset temperature;
determining that the heat dissipation mode is the refrigeration mode in a case that the temperature difference is less than or equal to a preset temperature difference threshold;
receiving an air particulate matter concentration value sent by the outdoor air particulate matter sensor in a case that the temperature difference is greater than the preset temperature difference threshold;
determining that the heat dissipation mode is the heat pipe mode in a case that the air particulate matter concentration value is less than or equal to a preset particulate matter concentration threshold;
receiving air supply humidity sent by the air supply humidity sensor in a case that the air particulate matter concentration value is greater than the preset particulate matter concentration threshold; and
determining that the heat dissipation mode is the fresh air mode in a case that the air supply humidity is less than or equal to a preset humidity threshold; and determining that the heat dissipation mode is the heat pipe mode in a case that the air supply humidity is greater than the preset humidity threshold.

3. The system for computer room temperature control according to claim 1 or 2, wherein the computer room fresh air system further comprises an air inlet device and an air exhaust device, wherein the air inlet device comprises a first fan, and the air exhaust device comprises a second fan; wherein controlling the heat dissipation system corresponding to the heat dissipation mode to dissipate heat from the cabinet comprises:
controlling the computer room fresh air system to turn on the first fan in a case that the heat dissipation mode is the fresh air mode; and
controlling the computer room fresh air system to turn on the second fan to dissipate heat from the cabinet after the first fan is turned on for a preset time period, wherein a rotational speed of the first fan and a rotational speed of the second fan are the same.

4. The system for computer room temperature control according to claim 3, wherein the air inlet device further comprises a third fan, a filter and an air supply pressure sensor, wherein after controlling the computer room fresh air system to turn on the second fan to dissipate heat from the cabinet after the first fan is turned on for the preset time period, the method comprising:
receiving an air supply pressure value sent by the air supply pressure sensor; and
controlling the computer room fresh air system to turn on the third fan to clean the filter in a case that the air supply pressure value is less than a preset air supply pressure threshold.

5. The system for computer room temperature control according to any one of claims 1 to 4, wherein the system for computer room temperature control further comprising a power supply system, wherein the refrigeration system is powered by alternating current, and the fresh air system and the heat pipe system are powered by direct current; wherein receiving the environmental data sent by the environmental information sensor in response to the air exhaust temperature being greater than the preset air exhaust temperature threshold and determining the heat dissipation mode based on the environmental data comprises:
detecting whether the power supply system provides alternating current in response to the air exhaust temperature being greater than the preset air exhaust temperature threshold; and
receiving the environmental data sent by the environmental information sensor in a case that the power supply system does not provide alternating current, and determining the heat dissipation mode based on the environmental data, wherein the heat dissipation mode comprises a fresh air mode and a heat pipe mode.

6. A computer room fresh air system, comprising: an air inlet device, wherein the air inlet device comprises a first fan, a second fan, and a filter, wherein the air inlet device is equipped with an air inlet, an air outlet, an air inlet zone, a filtration zone, and an air outlet zone, wherein the filtration zone is a middle location zone of the air inlet device, the air inlet zone is a location zone between the air inlet and the filtration zone, and the air outlet zone is a location zone between the air outlet and the filtration zone;
wherein the first fan is arranged at the air inlet zone and is configured to supply air to a computer room;
the second fan is arranged at the air outlet zone and is configured to clean the filter; and
the filter is configured to filter particulate matters in the air, wherein the filter comprises a mesh filter, a coarse filter and a medium-efficiency filter;
wherein the mesh filter is arranged at the air inlet and is configured to perform preliminary filtration of the particulate matters in the air;
the coarse filter is configured to perform further filtration of the particulate matters filtered by the mesh filter; and
the medium-efficiency filter is configured to perform further filtration of the particulate matters filtered by the coarse filter;
wherein the coarse filter and the medium-efficiency filter are arranged at the filtration zone, and the coarse filter is closer to the air inlet zone than the medium-efficiency filter.

7. The system according to claim 6, wherein the air inlet device further comprises an air supply pressure sensor, and the air supply pressure sensor is arranged at the air outlet zone;
the air supply pressure sensor is configured to monitor an air supply pressure value and control the second fan to rotate based on the air supply pressure value to clean the filter;
optionally, the air inlet device further comprises an outdoor temperature sensor, an outdoor air particulate matter sensor, and an air supply humidity sensor, wherein the air supply humidity sensor is arranged at the air outlet zone, the outdoor temperature sensor and an outdoor air humidity sensor are arranged at a zone between the air inlet and the first fan;
wherein the outdoor temperature sensor is configured to monitor an outdoor temperature;
the outdoor air particulate matter sensor is configured to monitor an outdoor air particulate matter concentration value; and
the air supply humidity sensor is configured to monitor air supply humidity.

8. An apparatus for computer room temperature control, comprising:
a receiving module, configured to receive an air exhaust temperature sent by an air exhaust temperature sensor in real time;
a determining module, configured to receive environmental data sent by an environmental information sensor in response to the air exhaust temperature being greater than a preset air exhaust temperature threshold, and determine a heat dissipation mode based on the environmental data, wherein the heat dissipation mode comprises a fresh air mode, a refrigeration mode, and a heat pipe mode; and
a heat dissipation module, configured to control a heat dissipation system corresponding to the heat dissipation mode to dissipate heat from a cabinet, wherein a heat dissipation system corresponding to the fresh air mode is a fresh air system, a heat dissipation system corresponding to the refrigeration mode is a refrigeration system, and a heat dissipation system corresponding to the heat pipe mode is a heat pipe system.

9. A device for computer room temperature control, comprising: a processor, and a memory storing a program for implementing a method for computer room temperature control;
wherein the memory is configured to store the program; and
the processor is configured to execute the program to implement the steps of the method according to any one of claims 1 to 5.

10. A storage medium having stored a program for implementing a method for computer room temperature control that, when executed by a processor, implements the method according to any one of claims 1 to 5.

11. A computer program product, comprising a computer program that, when executed by a processor, implements the method according to any one of claims 1 to 5.
